# EUROPEAN PATENT SPECIFICATION

(11) **EP 0 434 852 B1**
(45) Date of publication and mention of the grant of the patent: **17.05.1995**
(21) Application number: 89123873.5
(22) Date of filing: 23.12.1989
(51) Int. Cl.: G11C 8/00

(54) **Highly integrated multi-port semiconductor storage**
Hochintegrierter Halbleiterspeicher mit Mehrfachzugang
Mémoire à semi-conducteur à portes multiples hautement intégré

(43) Date of publication of application: 03.07.1991
(73) Proprietor: International Business Machines Corporation, Armonk, N.Y. 10504 (US)
(72) Inventor: Clemen, Rainer, Dipl.-Ing., D-7030 Böblingen (DE); Loehlein, Wolfdieter, D-7033 Herrenberg (DE)
(74) Representative: Schäfer, Wolfgang, Dipl.-Ing.

(56) References cited:
- EP-A- 0 145 497
- EP-A- 0 237 813
- US-A- 3 560 940

## Description

The invention relates to a highly integrated multi-port semiconductor storage according to the preamble of claim 1.

Storages permitting the parallel reading of two stored words or the simultaneous reading of a particular stored word and the writing of another word into another storage location are known in principle.

A semiconductor storage permitting two or more word lines to be simultaneously addressed is described in DE-OS 2,327,062. However, this storage has the disadvantage that the words read are not simultaneously available at the storage output but are combined in the storage to form a logical product. The simultaneous writing of a word into other storage locations is not possible.

Known from US Patent 3,675,218 is furthermore a storage arrangement, wherein information can be written into any random part, while information is read from another part different from the first one. Although this solution is technically elaborate, it only permits writing one word and simultaneously reading another. In IBM TDB, Vol. 19, No. 7, December 1976, a storage organization is described permitting the parallel reading of two stored words. From IEEE 1977, "International Solid State Circuit Conference", February 16, 1977, pp. 72 and 73, a 32 x 9 ECL dual address register is known permitting two separate parallel read operations of stored words.

Beside the apparent access port restrictions the technical means required in the prior art for sensing and selection as well as writing are relatively elaborate and do not permit optimum integration.

The previously described storages which are addressable in parallel have the common disadvantage that, unless additional registers or storages are provided, they are not suited for use as high-speed storages in advanced processors. Up-to-date processors comprise, as a rule, high-speed registers, the operation of which is partly concealed and which are partly available to the programmer. With many instructions, two operands are to be read from two different registers and to be fed to the arithmetic unit for processing; the result of this arithmetic operation is stored in one of the registers. In such a known processor, an instruction is executed as follows:
1. Reading two operands from different registers,
2. executing an arithmetical operation, such as an addition, subtraction or multiplication, and
3. feeding the result to one of the registers, i.e., the result is written into one of the registers.

In addition, it is frequently necessary to find a time gap in which other new information, for example from the main storage, can be written into one of the registers. With the storages known so far, which permit addressing only for reading two words, such operations can only be performed in series or partly in parallel. As a result, storage times accumulate which essentially influence the speed at which an instruction can be executed. To speed up operation, it would be desirable to have a storage whose ports to the individual registers can be used in parallel, i.e., in the present case to have at least three ports, one read port for each operand and one write port for the result. For addressing these ports to the registers, each of them is provided with an independent address decoder. As described, register banks with two ports are known from the above-mentioned literature (IEEE 1977). In highly integrated semiconductor technology it is relatively difficult and expensive to manage with only one storage cell per bit. In accordance with the two address systems, two cells are generally used for each bit, but these cells must always contain the same information. Care must be taken that information written by an address system into one cell of the pair also reaches the other cell of the pair. In the above-mentioned prior art citation, this is accomplished by coupling the cell pairs in the standby state, i.e., it is only after a cell has been written and is about to assume the standby state, that the coupling impresses the same information into the other cell of the pair. This storage has no third port.

US Patent 4,412,312 describes a storage where the storage locations are made up of at least two storage elements which, via coupling elements, are connected to associated but different bit lines as well as to separate word lines, and which have at least three independently selectable ports. The coupling elements respond to different polarities of changes in the reference potential of the storage elements.

A memory cell adapted for different combinations of simultaneous read and write operations is described in IBM Tech. Disc. Bul., Vol. 23, No.1, 6/80, pp. 180-186.

Another multi-port array cell is described in IBM Tech. Disc. Bul., Vol. 22, No.10, 3/80, pp. 4553-4554, and a multi-port asymmetrical memory cell is described in IBM Tech. Disc. Bul., Vol. 23, No.7A, 12/80, p.2822.

A semiconductor memory device provided with an improved precharge scheme for bit lines is known from EP-A-0 237 813. A plurality of bit lines are divided into a plurality of bit line group and a precharge control signal is applied only to precharge transistors in a selected bit line group.

EP-A-0 145 497 discloses a master slice type LSI which is constructed as a three port memory circuit in which respective cells exclusively utilized as memory circuits constituting respective memory regions can be accessed simultaneously. Each cell exclusively used as a memory circuit is constituted by a flip-flop circuit including two inverters which are connected in parallel opposition, a single write data input line and two read out data output lines which are connected to the flip-flop circuit through transfer gate circuits respectively and at least three word lines respectively and at least three word lines along which independent word signals are transmitted. The three transfer gate circuits are independently enabled and disabled based on the word signals transmitted over the word lines. The teaching of this document forms the preamble to claim 1.

The prior art cells do not meet the density and performance requirements, particularly of a fast byte-writable multi-port static random access memory.

It is therefore the object of the invention to provide a multi-port highly integrated static semiconductor storage which improves both the density and the write performance to allow a single byte select for a fast write or write-through operation.

The solution is described in the characterizing part of claim 1. Further improvements are described in claims 2 - 7.

To improve both the density and the write performance of the byte-writeable multi-port SRAM described above, it is suggested to use a multi-port cell with an asymmetrical flip-flop and a single device per write port, and to implement a write-byte control in the word line common to all attached cells.

Instead of integrating the write-byte device(s) into each memory cell, an extra AND circuit is provided which gates all write devices of a group of kx9 cells in a row (k=1, 2, 3, ...). The AND gate is only selected if both input signals, the main write word line signal WL and the unique write byte signal WBi, are activated. This approach is more area efficient and allows to optimize the cell design for a fast write performance without being limited too much by the cell size.

Provided that the multi-port cell contains inverter buffers in the read ports, the single-ended write can be accelerated significantly by an asymmetrical flip-flop with a weak feedback as storage element. Such a flip-flop is realized by a cross-coupled inverter pair. The first inverter uses devices slightly larger than minimum, adjusted to the size of the attached inverter buffers. The second inverter contains a minimum-width and long-channel NFET to reduce the countereffect when pulling up the flip-flop node 1 by the write NFET. This concept ensures that the written signal propagates rapidly to the read port.

To summarize, the proposed write-byte scheme for a CMOS static random access memory (SRAM) of the invention has the following major features and advantages:
○ Fully static multi-port memory cell with asymmetric flip-flop
   - sufficient driveability of first inverter (driving the preamplifier)
   - reduced countereffect (flip-flop with weak feedback)
○ Byte write control outside memory cell
   - all write port devices of a cell group within a row controlled by a common AND gate, selected by the main WL and the byte write control

This leads to the following advantages over the circuitry of the prior art:
○ Better write performance
   - 44% shorter write time with single write NFET and asymmetrical flip-flop
○ Higher array density by saving FETs.

In conclusion, the proposed write-byte scheme provides an optimal trade-off between density and performance. By using an asymmetrical flip-flop in conjunction with a single write port device and the byte-controlled section word line, the critical path delay through the fully static multi-port memory cell can be minimized for a fast write-through operation.

The invention will be described in detail below with reference to drawings which illustrate embodiments, in which
- Fig. 1: shows a typical circuit schematic of the multi-port cell within a storage matrix;
- Fig. 1a: shows a more detailed circuit of Fig. 1;
- Fig. 2: shows a block diagram of the write circuitry for a row of a multi-port SRAM;
- Fig. 3: shows a timing chart of the SRAM of Figs. 1 and 2;
- Fig. 4: shows a particularly favorable circuit diagram of the multi-port SRAM cell.

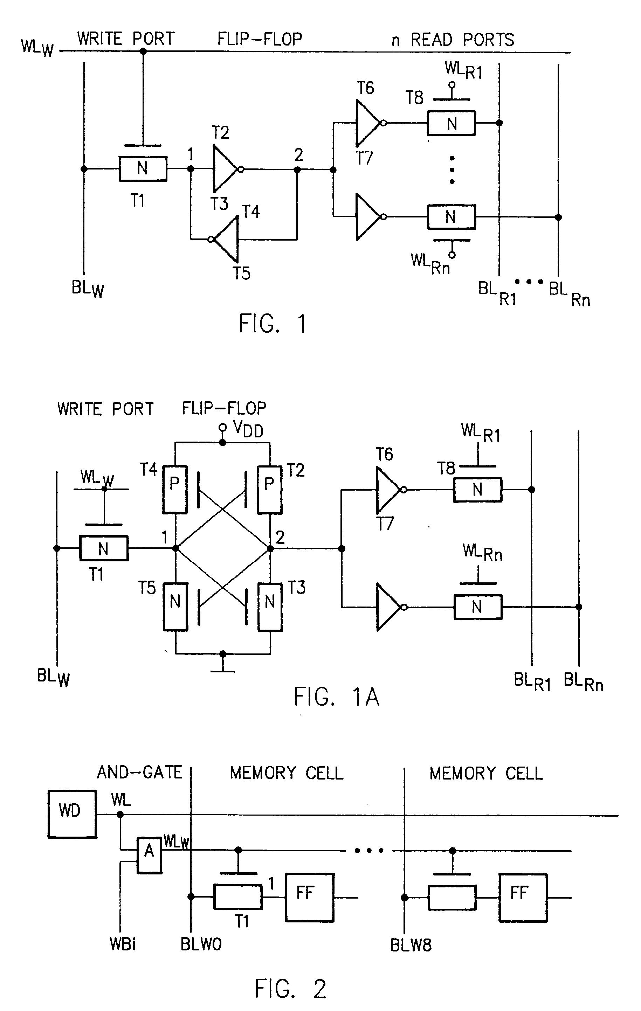

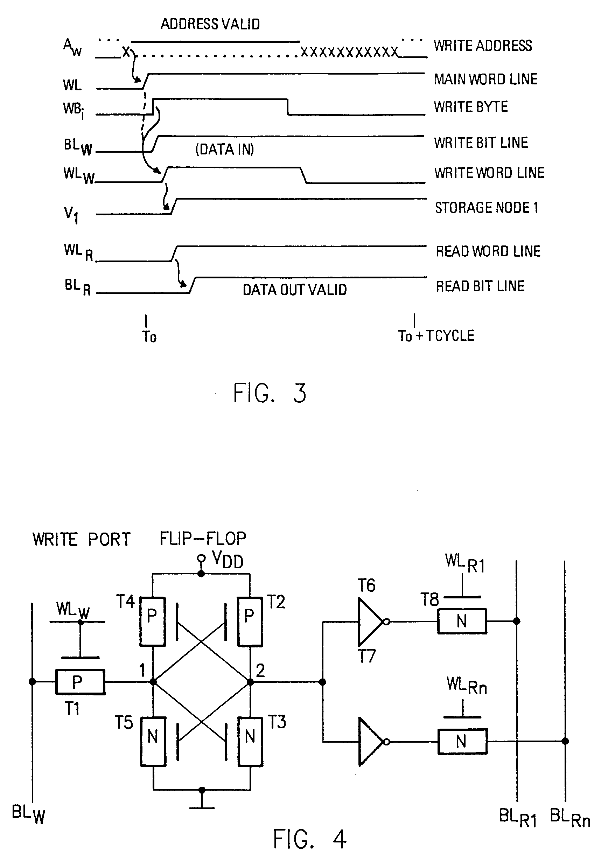

Referring to the circuitry of Fig. 1, the block diagram of Fig. 2 and the timing diagram in Fig. 3, the fast write operation or the write-through operation of the byte-writeable multi-port cell scheme is as follows:

It is assumed that a logical '0' is stored in the memory cell and that the bit lines are at a low level due to preceding write and/or read '0' operations.

At the beginning of the write operation the write address is set up. The write word decoder WD selects one of the main word lines, e. g., main word line WL goes to a high level after the last change of address Aw.

To selectively store data only into a particular block i of the cell array, the byte write clock WBi is activated. This signal is fed into a column of AND gates located at the edge of the block of cells. As soon as clock signal WBi goes high, one of these AND gates connected to the selected main word line WL is enabled to perform the final decoding, after which the associated block word line WLw rises, gating all write devices of the attached byte-organized group of cells.

Assuming that a logical '1' is to be stored in a selected cell, the respective data input and hence the write bit line BLw must be set to a high level (Fig. 1a). With the write-port NFET T1 being turned on, the cell node 1 is first charged towards a voltage of only VDD-VTn, i.e. a threshold voltage VTn below the power supply voltage VDD (Fig. 1a). This is sufficient to switch the high-gain flip-flop inverter T2/T3. As soon as the output of this inverter, i.e. cell node 2, has dropped below VDD-VTP (VTP = threshold voltage of PFET), the small load PFET T4 of the low-gain inverter T4/T5 turns on and starts charging node 1 to the full power supply voltage VDD. Thus, the final pull-up is achieved by the feedback effect. The high level obtained at node 1 propagates quickly through the flip-flop inverter T2/T3 and the attached inverting buffers T6/T7. This completes the write operation.

Provided the cell is also selected for a read operation, one or more read ports can be opened, depending on the status of the read address bits. This operation mode where the read address is the same as the write address is called WRITE-THROUGH operation. If a read-port is selected by the respective read word line, the new cell data is transmitted to the read bit line. To give an example: When the read word line WLR1 rises, the read port NFET T8 turns on and the read bit line BLR1 adopts the high voltage level from the inverting buffer T6/T7. Thus the data received from the input can quickly be written through the memory cell to the data output.

If a stored '1' were to be overwritten by a '0', the cell node 1 would be quickly discharged from VDD to ground via the write port NFET T1.

In Fig. 4 the write-port T1 is realized with a p-device. This step is advisable if the "write word line" is to drive a high load. In this case a high speed selection via the word driver is possible as the word line can be quickly discharged from VDD to 0. In that case, the flip-flop is set asymmetrically in a precisely inverted mode, i.e. T4 is of small dimensions, so that the writing of a '0' that is affected owing to the P device in the write port is accelerated.

## Claims

1. Highly integrated multi-port static random access memory (SRAM) comprising asymmetrical CMOS flip-flops (FF) as storage cells, further comprising a plurality of intersection bit and word lines forming crosspoints therebetween, a plurality of storage locations provided at the crosspoints and connected to the respective bit and word lines for selecting a single bit group, particularly a single byte for a fast write or write-through operation,
whereby a cross-coupled inverter pair (T2, T3; T4, T5) forms the asymmetrical CMOS flip-flop (FF), where the first flip-flop inventer (T2, T3) is designed to drive an output, and the second flip-flop inverter (T4, T5) contains a minimum-width and long-channel N field effect transistor (NFET) to reduce the countereffect when writing a high-level through the write port;
characterized
by inverter buffers or preamplifiers (T6, T7) being attached to the output of the assymetrical CMOS flip-flop and driving the bit lines;
by dividing the cell matrix in i blocks of k bit columns each, k = 1, 2, ...; and
by a column of AND gates (A) connected to every block, the AND gates linking the block word lines (WLw) to the respective main write word lines (WL) depending on the state of a unique write byte control signal (WBi).

2. Multi-port static random access memory (SRAM) as set forth in claim 1, characterized
by activating a byte-write clock signal (WBi) which is fed into a column of the AND gates (A) located at the edge of the block of cells, where one of these AND gates connected to the selected main word line (WL) is enabled to perform the final decoding as soon as the write clock signal (WBi) goes to the signal high level;
by gating all write devices of the attached group of cells;
by raising the potential on the associated block word line (WLw).

3. Multi-port static random access memory (SRAM), as set forth in claim 1 or 2, characterized
by using a multi-port cell with the asymmetrical flip-flop (FF) and a single device per write port, and
by implementing a write-bit group control in the write word line (WL) common to all attached multi-port cells.

4. Multi-port static random access memory (SRAM) as set forth in any one of claims 1 to 3,
characterized in
that each multi-port cell contains the inverter buffers in the read ports, and in that the single-ended write is accelerated significantly by an asymmetrical flip-flop (FF) with a weak feedback.

5. Multi-port static random access memory (SRAM) with asymmetrical flip-flops as cells of claims 1 or 4 characterized in
that the first inverter (T2, T3) contains devices slightly larger than minimum and adjusted to the device of the attached inverter buffer (T6, T7), and that the second (feedback) inverter contains a minimum-width and long-channel N-channel field effect transistor (T4) to prevent the countereffect when pulling up the flip-flop node (1) by the write N-channel field effect transistor (T1).

6. Multi-port static random access memory (SRAM), as set forth in any one of claims 1 - 5,
characterized in
that the bit groups consist of half bytes, bytes or multi-bytes.

7. Multi-port static random access memory (SRAM) as set forth in any one of the claims 1 to 6,
characterized in
that the field effect transistors (FETs) of the write ports are P-channel devices.

## Patentansprüche

1. Hochintegrierter statischer Speicher mit wahlfreiem Mehrfachzugriff (SRAM), asymmetrischen CMOS-Flip-Flopschaltungen (FF) als Speicherzellen, desweiteren einer Vielzahl sich schneidender Bit- und Wortleitungen, die untereinander Kreuzungspunkte bilden und einer Vielzahl Speicherplätze, welche an den Kreuzungspunkten liegen und mit den entsprechenden Bit- und Wortleitungen verbunden sind, um eine einzelne Bitgruppe, im besonderen ein einzelnes Byte für eine schnelle Schreiboperation oder Durchschreiboperation, auszuwählen,
wobei ein über Kreuz verschaltetes Inverterpaar (T2, T3; T4, T5) das asymmetrische CMOS-Flip-Flop (FF) bildet, wobei der erste Flip-Flop-Inverter (T2, T3) ausgelegt ist, um einen Ausgang anzusteuern und wobei der zweite Flip-Flop-Inverter (T4, T5) einen N-Kanal Feldeffekttransistor (NFET) mit minimaler Kanalbreite und großer Kanallänge enthält, um die beim Schreiben eines HIGH-Pegels durch das Schreibport auftretende Gegenwirkung zu reduzieren;
gekennzeichnet
durch Inverterpuffer oder Vorverstärker (T6, T7), die an den Ausgang des asymmetrischen CMOS-Flip-Flops angeschlossen sind und die Bitleitungen ansteuern;
durch Unterteilen der Zellenmatrix in i Blöcke aus k Bit-Spalten mit k = 1, 2, ...; und
durch eine Spalte UND-Gatter (A), die mit jedem Block verbunden sind, wobei die UND-Gatter in Abhängigkeit von einem eindeutigen Byte-Schreibsteuersignal (WBi) Verbindungen zwischen den Block-Wortleitungen (WLw) und den entsprechenden Haupt-Schreibwortleitungen (WL) herstellen.

2. Statischer Speicher mit wahlfreiem Mehrfachzugriff (SRAM), wie in Anspruch 1 ausgeführt, dadurch gekennzeichnet,
daß ein Byte-Schreibtaktsignal (WBi) aktiviert wird, welches in eine Spalte der UND-Gatter (A) eingespeist wird, die sich an der Seite des Zellenblockes befindet, wobei eines dieser UND-Gatter, das mit der ausgewählten Hauptwortleitung verbunden ist, freigegeben wird, um das letztendliche Decodieren durchzuführen, sobald das Schreibtaktsignal (WBi) auf den HIGH-Signalpegel geht;
daß alle Schreibbauelemente der angeschlossenen Gruppe von Zellen durchgeschaltet werden;
daß das Potential auf der zugeordneten Block-Wortleitung (WLw) angehoben wird.

3. Statischer Speicher mit wahlfreiem Mehrfachzugriff (SRAM), wie in einem der Ansprüche 1 oder 2 ausgeführt, dadurch gekennzeichnet,
daß eine Zelle mit Mehrfachzugang mit dem asymmetrischen Flip-Flop (FF) und ein einzelnes Element pro Schreibport verwendet werden und
daß eine Bitgruppen-Schreibsteuerung in der Schreibwortleitung (WL) implementiert wird, die allen angeschlossenen Zellen mit Mehrfachzugang gemeinsam ist.

4. Statischer Speicher mit wahlfreiem Mehrfachzugriff (SRAM), wie in einem der Ansprüche 1 bis 3 ausgeführt, dadurch gekennzeichnet,
daß jede Mehrkanal-Zelle invertierende Pufferspeicher in den Leseports enthält und dadurch, daß eine einseitige Schreiboperation durch ein asymmetrisches Flip-Flop (FF) mit einer schwachen Rückkopplung wesentlich beschleunigt wird.

5. Statischer Speicher mit wahlfreiem Mehrfachzugriff (SRAM), und mit aus asymmetrischen Flip-Flops bestehenden Speicherzellen nach einem der Ansprüche 1 bis 4, dadurch gekennzeichnet,
daß der erste Inverter (T2, T3) Bauelemente enthält, die etwas größer als minimal möglich sind und die an die Bauelemente des angeschlossenen Inverterpuffers (T6, T7) angepaßt sind und daß der zweite (Rückkopplungs-) Inverter einen N-Kanal-Feldeffekttransistor (T4) mit minimaler Kanalbreite und großer Kanallänge enthält, um eine Gegenwirkung zu verhindern, wenn das Potential des Flip-Flop-Knotens (1) durch den Schreib-N-Kanal-Feldeffekttransistor (T1) nach oben gezogen wird.

6. Statischer Speicher mit wahlfreiem Mehrfachzugriff (SRAM), wie in einem der Ansprüche 1 bis 5 ausgeführt, dadurch gekennzeichnet,
daß die Bitgruppen aus Halbbytes, Bytes oder mehreren Bytes bestehen.

7. Statischer Speicher mit wahlfreiem Mehrfachzugriff (SRAM), wie in einem der Ansprüche 1 bis 6 ausgeführt, dadurch gekennzeichnet,
daß die Feldeffekttransistoren (FET) der Schreibports P-Kanal-Bauelemente sind.

## Revendications

1. Mémoire à accès direct statique à ports multiples hautement intégrée (SRAM) comprenant des bascules bistables (FF) CMOS asymétriques en tant que cellules d'emmagasinage, comprenant en outre une pluralité de lignes de bit et de mot d'intersection formant des points de croisement entre elles, une pluralité de positions de mémoire fournies aux points de croisement et connectées aux lignes de bit et de mot respectives pour sélectionner un seul groupe de bits, particulièrement un seul multiplet, pour une opération d'écriture rapide ou directe,
ce qui fait qu'une paire d'inverseurs couplés en croix (T2, T3; T4, T5) forme la bascule bistable (FF) CMOS, où le premier inverseur bistable (T2, T3) est conçu pour exciter une sortie, et le deuxième inverseur bistable (T4, T5) contient un transistor à effet de champ N à canal long et à largeur minimale (NFET) pour réduire le contre effet lors de l'écriture d'un niveau haut au port d'écriture;
caractérisée
par des tampons inverseurs ou préamplificateurs (T6, T7) qui sont connectés à la sortie de la bascule bistable CMOS asymétrique et qui excitent les lignes de bit;
par la division de la matrice de cellules en i blocs de k colonnes binaire chacun, k = 1, 2, ...); et
par une colonne de portes ET (A) connectées à chaque bloc, les portes ET reliant les lignes de mot de bloc (WLw) aux lignes de mot d'écriture principales respectives (WL) suivant l'état d'un signal de contrôle de multiplet d'écriture unique (WRi).

2. Mémoire à accès direct statique à ports multiples (SRAM) selon la revendication 1, caractérisée par:
l'activation d'un signal d'horloge d'écriture de bit (WBi) qui est envoyé dans une colonne des portes ET (A) placées au bord du bloc de cellules, où une de ces portes ET connectées à la ligne de mot principale sélectionnée (WL) est conditionnée pour accomplir le décodage final aussitôt que le signal d'horloge d'écriture (WBi) atteint le niveau haut de signal;
le conditionnement de tous les dispositifs d'écriture du groupe de cellules connecté;
l'élévation du potentiel sur la ligne de mot de bloc associée (WLw).

3. Mémoire à accès direct statique à ports multiples (SRAM) selon les revendications 1 ou 2, caractérisée par
l'utilisation d'une cellule à ports multiples avec la bascule asymétrique (FF) et un seul dispositif par port d'écriture, et
la réalisation d'un contrôle de groupe de bits d'écriture dans la ligne de mot d'écriture (WL) commune à toutes les cellules à ports multiples connectées.

4. Mémoire à accès direct statique à ports multiples (SRAM) selon l'une quelconque des revendications 1 à 3,
caractérise en ce que
chaque cellule à ports multiples contient les tampons inverseurs dans les ports de lecture, et en ce que l'écriture à une seule extrémité est accélérée de façon significative par une bascule bistable asymétrique (FF) avec une faible réaction.

5. Mémoire à accès direct statique à ports multiples (SRAM) ayant des bascules bistables asymétriques en tant que cellules selon les revendications 1 ou 4, caractérisée en ce que
le premier inverseur (T2, T3) contient des dispositifs légèrement plus grands que le minimum et réglés sur le dispositif du tampon inverseur connecté (T6, T7), et en ce que le deuxième inverseur (réaction) contient un transistor à effet de champ de canal N à canal long et à largeur minimale (T4) afin d'empêcher le contre effet lors du tirage vers le haut du noeud bistable (1) par le transistor à effet de champ de canal N d'écriture (T1).

6. Mémoire à accès direct statique à ports multiples (SRAM) selon l'une quelconque des revendications 1-5, caractérisée en ce que
les groupes de bits sont constitués de demi-multiplets, de multiplets ou de multiples multiplets.

7. Mémoire à accès direct statique à ports multiples (SRAM) selon l'une quelconque des revendications 1 à 6,
caractérisée en ce que
les transistors à effet de champ (FET) des ports d'écriture sont des dispositifs de canal P.
